Europäisches Patentamt

European Patent Office

Office européen des brevets

(11) Veröffentlichungsnummer: **0 573 116 A1**

## EUROPÄISCHE PATENTANMELDUNG

(21) Anmeldenummer: **93201548.0**

(22) Anmeldetag: **01.06.93**

(51) Int. Cl.⁵: **H04L 7/04**, H04L 1/00

(30) Priorität: **05.06.92 DE 4218529**

(43) Veröffentlichungstag der Anmeldung:
**08.12.93 Patentblatt 93/49**

(84) Benannte Vertragsstaaten:
**DE FR GB SE**

(71) Anmelder: **Philips Patentverwaltung GmbH
Wendenstrasse 35c
D-20097 Hamburg(DE)**

(84) **DE**

(71) Anmelder: **PHILIPS ELECTRONICS N.V.
Groenewoudseweg 1
NL-5621 BA Eindhoven(NL)**

(84) **FR GB SE**

(72) Erfinder: **Zimmermann, Gerd, Philips
Patentverwaltung GmbH
Wendenstrasse 35
W-2000 Hamburg 1(DE)**
Erfinder: **Petersen, Jürgen, Philips
Patentverwaltung GmbH
Wendenstrasse 35
W-2000 Hamburg 1(DE)**

(74) Vertreter: **Volmer, Georg, Dipl.-Ing. et al
Philips Patentverwaltung GmbH,
Wendenstrasse 35c
D-20097 Hamburg (DE)**

(54) **Übertragungssystem mit einem Decoder mit Bitfehlerratenschätzung und/oder Wortsynchronisation.**

(57) Die Erfindung betrifft ein Übertragungssystem für ein aus einer Informationsdatenfolge (11) und mindestens einer Redundanzdatenfolge (12, 13, 14) bestehendes Digitalsignal (1), wobei die Redundanzdatenfolge (12, 13, 14) aus der Informationsdatenfolge (11) mittels eines Codes gebildet ist, mit einem ersten Speicher (Se) zum Einlesen des Informationssignals (11), mit einer Verknüpfungseinrichtung (Ve) zur Verknüpfung von Speicherinhalten (S1..S10) des ersten Speichers (Se) mit Daten des Redundanzsignals (12, 13, 14) zu mindestens einer Syndromfolge (16, 17, 18), mit einer Syndromregistereinrichtung (SR) mit mindestens einem weiteren Speicher (20, 21, 22) zum Einlesen der Syndromfolge (16, 17, 18), mit einer Entscheidungseinrichtung (4), die eine Summiereinrichtung (40) zur Bildung einer Summe (S) aus am Speicher (20, 21, 22) der Syndromregistereinrichtung (SR) abgreifbaren Werten (W1..WM) und eine erste Entscheidungseinheit (41) zur Ermittlung eines ersten Fehlersignals (e1) aus der Summe (S) aufweist, und mit einem Verknüpfungsglied (E10) zur Verknüpfung des ersten Fehlersignals (e1) mit einer aus dem ersten Speicher (Se) auszulesenden Informationsdatenfolge (8) zu einer decodierten Informationsdatenfolge (3).

Zur Verbesserung des Übertragungssystems wird vorgeschlagen, daß die Entscheidungseinrichtung (4) eine zweite Entscheidungseinheit (42) zur Schätzung einer Fehlerrate (ŝ) des decodierten Informationssignals (3) und/oder eine dritte Entscheidungseinheit (43) zur Ermittlung eines dritten Fehlersignals (e3) zur Synchronisation des Digitalsignals (1) aufweist, wobei die zweite (42) und dritte (43) Entscheidungseinheit jeweils zur Auswertung der aus den Binärwerten (W1..WM) der Speichereinrichtung (SR) gebildeten Summe (S) vorgesehen sind.

EP 0 573 116 A1

FIG.1

Die Erfindung betrifft ein Übertragungssystem mit einem Empfänger für ein aus einer Informationsdatenfolge und mindestens einer Redundanzdatenfolge bestehendes Digitalsignal, wobei die Redundanzdatenfolge aus der Informationsdatenfolge mittels eines Codes gebildet ist, mit einem ersten Speicher zum Einlesen des Informationssignals, mit einer Verknüpfungseinrichtung zur Verknüpfung von Speicherinhalten des ersten Speichers mit Daten des Redundanzsignals zu mindestens einer Syndromfolge, mit einer Syndromregistereinrichtung mit mindestens einem weiteren Speicher zum Einlesen der Syndromfolge, mit einer Entscheidungseinrichtung, die eine Summiereinrichtung zur Bildung einer Summe aus am Speicher der Syndromregistereinrichtung abgreifbaren Werten und eine erste Entscheidungseinheit zur Ermittlung eines ersten Fehlersignals aus der Summe aufweist, und mit einem Verknüpfungsglied zur Verknüpfung des ersten Fehlersignals mit einer aus dem ersten Speicher auszulesenden Informationsdatenfolge zu einer decodierten Informationsdatenfolge.

Die Erfindung betrifft auch einen Decoder für ein solches Übertragungssystem. Derartige Übertragungssysteme werden in der Nachrichtenübertragung zur Sicherung einer als Digitalsignal zu übertragenden Nachricht gegen übertragungsfehler eingesetzt. Hierzu wird zusätzlich zu einer Informationsdatenfolge mindestens eine Redundanzdatenfolge übertragen, die aus dem Informationssignal mittels eines Codes gebildet ist und die mit Hilfe eines empfangsseitig angeordneten Decoders zur Fehlerkorrektur ausgenutzt werden kann. Bei der Codierung durch einen Faltungscode, beispielsweise durch einen sogenannten systematischen, orthogonalen Faltungscode wird aus der Informationsdatenfolge durch Verknüpfung einzelner Binärwerte der Informationsdatenfolge die Redundanzdatenfolge bzw. die Redundanzdatenfolgen abgeleitet. Die zu übertragende Sendedatenfolge ist dabei in der Regel aus aus der Informationsdatenfolge und der Redundanzdatenfolge gebildeten Codewörtern entsprechend einem Codewortraster zusammengesetzt. Diese Codewörter müssen auf der Empfangsseite im Decoder wieder in Informationsdatenfolge und Redundanzdatenfolge getrennt werden. Hierzu ist meist eine Wortsynchronisation bezüglich des Codewortrasters erforderlich.

Aus US 3,728,678 ist ein Decoder der eingangs genannten Art bekannt. Wie in Fig. 4 der US 3,728,678 dargestellt ist, wird zur Codierung eine Informationsdatenfolge einerseits direkt übertragen, andererseits wird die Informationsdatenfolge in ein Schieberegister eingelesen, wobei vorgebbare Speicherinhalte des Schieberegisters in einer Verknüpfungseinrichtung zu einer Redundanzdatenfolge miteinander verknüpft werden. Die Verknüpfungseinrichtung liefert somit die Redundanzdatenfolge, die ebenfalls übertragen wird. Auf der Empfangsseite wird im Decoder die informationsdatenfolge wiederum in ein Schieberegister eingelesen. Der Decoder weist außerdem eine Verknüpfungseinrichtung zur Verknüpfung von Speicherinhalten des Schieberegisters mit Daten der Redundanzdatenfolge zu einer Syndromfolge auf. Die Syndromfolge wird in eine Syndromregistereinrichtung eingelesen. Im Decoder ist darüber hinaus eine Entscheidungseinrichtung (Majority logic Circuit) zur Ermittlung eines Fehlersisgnals vorgesehen, das mit einer aus dem Schieberegister ausgelesenen Informationsdatenfolge verknüpft wird. Das Fehlerzignal wird aus Binärwerten ermittelt, die aus Speicherinhalten der Syndromregistereinrichtung ableitbar sind. Hierzu werden die Binärwerte in einer Summiereinrichtung zu einer Summe aufsummiert, wobei zur Ermittlung des Fehlersignals abgefragt wird, ob die Summe eine vorgebbare Schwelle übersteigt.

Der Erfindung liegt die Aufgabe zugrunde, ein Übertragungssystem der eingangs genannten Art zu verbessern.

Diese Aufgabe wird bei einem Übertragungssystem der eingangs genannten Art dadurch gelöst, daß die Entscheidungseinrichtung eine zweite Entscheidungseinheit zur Schätzung einer Fehlerrate des decodierten Informationssignals und/- oder eine dritte Entscheidungseinheit zur Ermittlung eines dritten Fehlersignals zur Synchronisation des Digitalsignals aufweist, wobei die zweite und dritte Entscheidungseinheit jeweils zur Auswertung der aus den Werten der Speichereinrichtung gebildeten Summe vorgesehen sind.

Die Erfindung geht dabei von der Erkenntnis aus, daß normalerweise zur Synchronisation der Empfangsdatenfolge eine regelmäßige Übertragung von Synchronisationswörtern in einer Sendedatenfolge notwendig wäre, wodurch jedoch eine Reduktion der Nutzdatenrate sowie zusätzliche Einrichtungen zur Erkennung der Synchronisationswörter notwendig wären. Auch bei der Schätzung der Fehlerrate der decodierten Informationsdatenfolge durch eine zusätzliche fehlererkennende Codierung können sowohl eine weitere Reduktion der Nutzdatenrate, als auch zusätzliche Einrichtungen zur Fehlerdetektion notwendig werden. Durch die Auswertung der zur Korrektur der Informationsdatenfolge ohnehin ermittelten Summe auch zur Fehlerratenschätzung sowie gegebenenfalls zu einer Wortsynchronisation kann eine vorhandene Nutzdatenrate voll ausgeschöpft werden. Eine zusätzliche Codierung für eine Fehlerratenschätzung bzw. eine Wortsynchronisation wird nicht notwendig. Der Decoder arbeitet dabei nach folgendem Verfahren: Im Empfänger wird die Empfangsdatenfolge einem ersten Speicher zugeführt. Die Redundanzdatenfolge wird mit Speicherinhalten des Speichers, d.h. mit zeitlich verzögerten Werte der empfangenen Informationsdatenfolge, zu mindestens einer Syndromfolge beispielsweise mittels EXCLUSIV-ODER-Verknüpfungen verknüpft. Diese Syndromfolgen werden in Speicher der Syndromregistereinrichtung eingelesen. Die Speicher der Syndromregistereinrichtung weisen codespezifische Abgriffe für die Werte auf, die in der Summiereinrichtung der Entscheidungseinrichtung zur Summe addiert werden. Die erste Entscheidungseinheit ermittelt, ob diese Summe über oder unter einer vorgebbaren ersten Schwelle liegt. Liegt die Summe über der vorgebbaren ersten Schwelle, so liegt mit hoher Wahrscheinlichkeit an der augenblicklichen Position der Informationsdatenfolge ein Fehler vor. Zur Korrektur wird dann am Ausgang der Entscheidungseinrichtung ein Fehlersymbol, das den Wert 1 aufweist, ausgegeben. Dieses Fehlersymbol des ersten Fehlersignals wird mit dem entsprechend verzögerten Informationsbit der Informationsdatenfolge EXCLUSIV-ODER-verknüpft, so daß eine Fehlerkorrektur erfolgt. Liegt die in der Entscheidungseinrichtung ermittelte Summe unter der vorgebbaren ersten Schwelle, so beträgt das Fehlersymbol des ersten Fehlersignals 0, so daß der entsprechende Wert der Informationsdatenfolge durch die EXCLUSIV-ODER-Verknüpfung nicht verändert wird.

Zur Beurteilung der Zuverlässigkeit einer durchgeführten Fehlerkorrektur, d.h. zur Ermittlung einer Fehlerrate der decodierten Informationsdatenfolge, wird ein zweites Fehlersignal mit Hilfe der zweiten Entscheidungseinheit erzeugt. Das zweite Fehlersignal wird ebenfalls aus der in der Summiereinrichtung der Entscheidungseinrichtung ermittelten Summe bestimmt. So wird für das zweite Fehlersignal der Wert 1 angegeben, wenn die Summe innerhalb eines vorgebbaren Schwellwertebereichs liegt.

Da die Informationsdatenfolge und die Redundanzdatenfolgen in der Regel als aus Codewörtern zusammengesetztes Multiplexsignal in zeitlich aufeinanderfolgenden Zeitscheiben übertragen werden, ist eine genaue zeitliche Steuerung des Decoders zum Demultiplexen der Empfangsdatenfolge, d.h. zur Ermittlung des Codewortrasters notwendig. Hierzu kann mittels der dritten ebenfalls aus der in der Summiereinrichtung gewonnenen Summe, d.h. aus den aufsummierten Binärwerten der Abgriffe der Syndromregister, ein drittes Fehlersignal erzeugt werden. Dabei nimmt ein Bit des dritten Fehlersignals den Wert 1 an, wenn die Summe eine vorgebbare dritte Schwelle überschreitet. Das dritte Fehlersignal kann auf einfache Weise zur Steuerung des Demultiplexers beim Trennen von Informationsdatenfolge und Redundanzdatenfolge bzw. der Redundanzdatenfolgen verwendet werden, da ein häufiges überschreiten der dritten Schwelle auf eine falsche Synchronisation des Codewortrasters schließen läßt. Die Schwellwerte hängen dabei vom speziellen Faltungscode ab, der bei der Codierung der Empfangsdatenfolge verwendet wird. Im Decoder kann sowohl die zweite und dritte Entscheidungseinheit gemeinsam, als auch lediglich die zweite oder die dritte Entscheidungseinheit einseln vorgesehen werden.

Eine einfache und sichere Trennung von Informationsdatenfolge und Redundanzdatenfolge wird dadurch erreicht, daß der Decoder einen Seriell/Parallel-Wandler zur Trennung der Empfangsdatenfolge in eine Informationsdatenfolge und in mindestens eine Redundanzdatenfolge aufweist, wobei das dritte Fehlersignal zur Ableitung eines Steuersignals zur Synchronisation des Seriell/Parallel-Wandlers vorgesehen ist.

Die Korrektur einer fehlerhaften Informationsdatenfolge wird dadurch ermöglicht, daß die erste Entscheidungseinheit zur Abfrage, ob die Summe eine erste vorgebbare Schwelle übersteigt, vorgesehen ist.

Eine Fehlerratenschätzung der decodierten Informationsdatenfolge wird dadurch ermöglicht, daß die zweite Entscheidungseinheit zur Abfrage, ob die Summe innerhalb eines vorgebbaren Summenwertebereichs liegt, vorgesehen ist, wobei die Fehlerrate aus der Häufigkeit der Summenwerte der Summe ermittelt wird, die während eines vorgebbaren zweiten Zeitabschnitts innerhalb des vorgebbaren Summenwertebereichs liegen. Dabei ist es insbesondere bei einer ungeraden Anzahl von Werten sinnvoll, für die Grenzwerte des Summenwertebereichs denselben zweiten Schwellwert zu verwenden, der sich aus der Hälfe der um 1 erhöhten Anzahl der Werte ergibt.

Eine Wortsynchronisation bezüglich des Codewortrasters der Empfangsdatenfolge wird dadurch gewährleistet, daß die dritte Entscheidungseinheit zur Abfrage, ob die Summe größer oder gleich eine vorgebbare dritte Schwelle ist, vorgesehen ist, wobei eine verschiebung der Empfangsdatenfolge dann erfolgt, wenn die Summenwerte der Summe, die größer oder gleich der vorgebbaren dritten Schwelle sind, während eines vorgebbaren Zeitabschnitts eine vorgebbare Häufigkeit überschreiten.

Dadurch, daß der Decoder eine Auswerteeinrichtung zur Auswertung mindestens eines Fehlersignals aufweist, wobei zur Schätzung der Fehlerrate der decodierten Informationsdatenfolge eine mit der zweiten Entscheidungseinheit verbundene erste Auswerteeinheit und/oder zur Ermittlung des Steuersignals eine mit der dritten Entscheidungseinheit verbundene zweite Auswerteeinheit vorgesehen ist, können auf einfache Weise Informationen bezüglich einer geschätzten Fehlerrate sowie ein Steuersignal zur Steuerung des Seriell/Parallel-Wandlers zur Trennung der Empfangsdatenfolge in Informationsdatenfolge und Redundanzdatenfolge erzeugt werden.

Eine erhöhte Zuverlässigkeit bei der Steuerung der Wortsynchronisation, d.h. bei der Steuerung des Seriell/Parallel-Wandlers kann dadurch erreicht werden, daß die zweite Auswerteeinheit auch mit der zweiten Entscheidungseinheit verbunden ist.

Eine Korrektur der Syndromregistereinrichtung wird dadurch ermöglicht, daß ein Schalter zur Korrektur der weiteren Speicher vorgesehen ist, dem das erste Fehlerbinärsignal zugeführt wird.

Im folgenden wird die Erfindung anhand der in den Figuren dargestellen Ausführungsbeispiele näher erläutert.

Es zeigen:

Fig. 1    ein übertragungssystem mit einem Coder und einem Decoder,

Fig. 2    ein Ausführungsbeispiel für eine Entscheidungseinrichtung und eine Auswerteeinrichtung und

Fig. 3    ein Ausführungsbeispiel für einen Decoder.

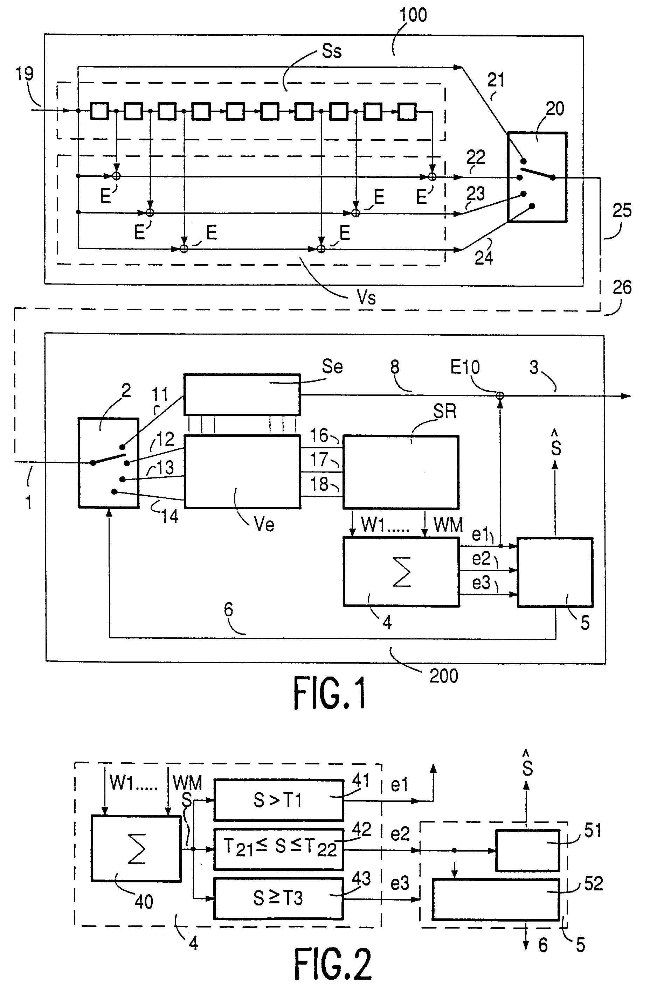

Das in Fig. 1 dargestellte übertragungssystem enthält einen Coder 100, dem eine zu codierende Binärdatenfolge 19 zugeführt wird. Am Ausgang des Coders 100 liegt eine zu sendende Sendedatenfolge 25, die über einen übertragungsKanal 26 übertragen wird. Am Eingang des Decoders 200 liegt eine Empfangsdatenfolge 1, die decodiert wird, so daß am Ausgang des Decoders eine decodierte Binärdatenfolge 3 erzeugt wird. Der Coder 100 weist einen ersten Speicher auf, dem die zu codierende Binärdatenfolge 19 zugeführt wird. Der Zugriff auf die einzelnen Speicherinhalte dieses ersten Speichers und der im folgenden noch verwendeten weiteren Speicher ist mittels Adresszeigern für Schreiben und Lesen der Speicherinhalte so organisiert, daß die Speicher die Funktion eines Schieberegisters erfüllen. Da es nur auf die mit den Speichern realisierte Funktion eines Schieberegisters ankommt, werden beim Ausführungsbeispiel diese Speicher im folgenden als Schieberegister bezeichnet. Für das Wesen der Erfindung ist es letztlich unwesentlich ob der Fachmann einzelne Speicher beziehungsweise einzelne Speicherbereiche eines größeren Speichers oder auch tatsächlich ein Schieberegister verwendet.

Die Binärdatenfolge 19 liegt gleichzeitig an einem Zweig 21 eines Multiplexers 20 an. Einzelne Speicherstellen des Schieberegister Ss sind mittels EXCLUSIV-ODER-Verknüpfungsgliedern E logisch kombinierbar. Aus den mit Hilfe der Verknüpfungsglieder E gebildeten Prüfbits werden Redundanzdatenfolgen 22, 23, 24 gebildet, die im Takt der Informationsdatenfolge 21 parallel ausgegeben werden. Die Informationsdatenfolge 21 sowie die drei Redundanzdatenfolgen 22, 23, 24 werden in einem Multiplexer 20 in eine serielle zu übertragende Sendedatenfolge 25 mit erhöhtem Bittakt umgewandelt.

Auf der Empfangsseite werden die Empfangsdatenfolge 1 in einem Demultiplexer ( = Seriell/Parallel-Wandler) 2 in die empfangene Informationsdatenfolge 11 sowie in die drei Redundanzdatenfolgen 12, 13, 14 getrennt. Die Informationsdatenfolge 11 wird in ein Schieberegister Se eingelesen, während die Redundanzdatenfolgen 12, 13, 14 zusammen mit der Informationsdatenfolge 11 in einer Verknüpfungseinrichtung Ve zu Syndromfolgen 16, 17, 18 umgewandelt werden. Die Verknüpfungseinrichtung Ve entspricht dabei vom Aufbau her der Verknüpfungseinrichtung Vs des Coders 100. Die Sydromfolgen 16, 17, 18 werden in einer Syndromregistereinrichtung SR in Schieberegister eingelesen. Diese Schieberegister weisen M codespezifische Abgriffe auf, an denen Binärwerte $W1..WM$ abgreifbar sind. Die Binärwerte $W1..WM$ werden einer Entscheidungseinrichtung 4 zugeführt, die hieraus drei Fehlersignale e1, e2, e3 bildet. Das erste Fehlersignal e1 wird einem EXCLUSIV-ODER-Gatter E10 zugeführt, das die aus dem Schieberegister Se auszulesende Informationsdatenfolge und das erste Fehlersignal e1 zu einem decodierten Informationssignal 3 verknüpft. Das zweite und dritte Fehlersignal e2, e3 werden an eine Auswerteeinrichtung 5 weitergeleitet, die hieraus eine Bitfehlerrate $\hat{s}$ schätzt sowie ein Steinersignal 6 zur Synchronisation des Demultiplexers 2 erzeugt.

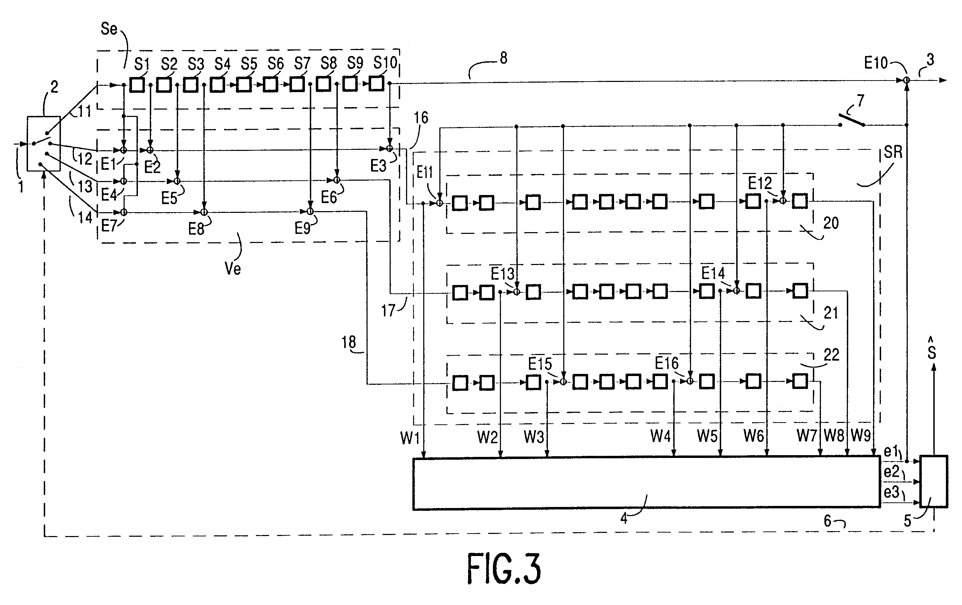

Das in Fig. 1 dargestellte digiale Übertragungssystem ist für die Codierung einer Informationsdatenfolge konzipiert, die auf einem systematischen, orthogonalen (n, k, l) Faltungscode basiert. Dabei kennzeichnet n die Anzahl der Gesamtbits eines aus Informationsbits und Redundanzbits gebildeten Codewortes, d.h. die Anzahl der Bits, die zur übertragung eines Informationsbits benötigt werden. K kennzeichnet die Anzahl der Datenbits, während 1 die Länge der Schieberegister Ss, Se und SR kennzeichnet. Für das in Fig. 1 dargestellte Ausführungsbeispiel gilt beispielsweise: n = 4, k = 1, l = 10. Diese Werte werden dem in Fig. 3 dargestellten Ausführungsbeispiel zugrunde gelegt. Hieraus ergibt sich, daß für jedes zu übertragende Datenbit (n-k), d.h. drei Prüfbits durch die Verknüpfungseinrichtung Vs erzeugt werden, die als Redundanzdatenfolgen 22, 23, 24 gemeinsam mit der Informationsdatenfolge 21 zur Sendedatenfolge 25 vereinigt werden. Anstelle einer Parallel/Seriell-Wandlung können die Informationsdatenfolge sowie die Redundanzdatenfolgen auch auf separaten Übertragungsstrecken übertragen werden. In diesem Fall kann auf Multiplexer 20, Demultiplexer 2 sowie eine Synchronisation des Demultiplexer 2 verzichtet werden. Der in Fig. 1 dargestellte Decoder 200

beruht auf einem sogenannten Majoritäts-Decodierverfahren, wie dies beispielsweise in "Treshold Decoding" von James L. Massey beschrieben ist.

Eine Ausgestaltung für die Verknüpfungseinrichtung Ve sowie die Syndromregistereinrichtung SR wird im Zusammmenhang mit Fig. 3 erläutert. Zum prinzipiellen Verständnis der Funktionsweise des in Fig. 1 dargestellten Decoders 200 ist auszuführen, daß die Empfangsdatenfolge 1 durch die Seriell/Parallel-Wandlung des Demultiplexers 2 zunächst in die Informationsdatenfolge 11 und in die drei Redundanzdatenfolgen 12, 13, 14 getrennt wird. Die Informationsdatenfolge 11 wird in das Schieberegister Se beispielsweise der Länge 1 = 10 eingelesen, während die Redundanzdatenfolgen 12, 13, 14 getrennt mit unterschiedlich zeitlich verzögerten Bits der Speicherinhalte des Schieberegisters Se zu n-k gleich 3 Syndromfolgen in der Verknüpfungseinrichtung Ve EXCSUSIV-ODER-verknüpft werden. Die Syndromfolgen 16, 17, 18 am Ausgang der Verknüpfungseinrichtung Ve werden getrennt in n-k gleich 3 Schieberegister der Länge 1 gleich 10 eingelesen. M code-spezifische Abgriffe der Schieberegister der Syndromregistereinrichtung SR liefern die Binärwerte W1..WM. Die weitere Verarbeitung der Binärwerte W1..WM zu Fehlersignalen e1, e2, e3 und die Ermittlung der geschätzten Bitfehlerrate $\hat{s}$ sowie des Steuersignals 6 durch die Auswerteeinrichtung 5 werden im Zusammenhang mit Fig. 2 erläutert.

Fig. 2 zeigt ein Ausführungsbeispiel einer Entscheidungseinrichtung 4 und eine Auswerteeinrichtung 5 für einen in Fig. 1 dargestellten Decoder. Die Entscheidungseinrichtung 4 weist eine Summiereinrichtung 40 auf, der Binärwerte W1..WM zugeführt werden. Eine aus den Binärwerten W1..WM gebildete Summe S am Ausgang der Summiereinrichtung 40 wird einer ersten Entscheidungseinheit 41, einer zweiten Entscheidungseinheit 42 sowie einer dritten Entscheidungseinheit 43 zugeführt. Am Ausgang der ersten Entscheidungseinheit 41 liegt ein erstes Fehlersignal e1, am Ausgang der zweiten Entscheidungseinheit 42 liegt ein zweites Fehlersignal e2, während am Ausgang der dritten Entscheidungseinheit 43 ein drittes Fehlersignal e3 auftritt. Das zweite Fehlersignal e2 wird einer ersten Auswerteeinheit 51 der Auswerteeinrichtung 5 zugeführt, während das dritte Fehlersignal e3 an eine zweite Auswerteeinheit 52 weitergeleitet wird. Am Ausgang der ersten Auswerteeinheit 51 liegt das eine geschätzte Bitfehlerrate kennzeichnende Signal $\hat{s}$, während am Ausgang der zweiten Auswerteeinheit 52 ein Steuersignal 6 abgreifbar ist.

Im folgenden wird bei der Beschreibung der Funktion der Entscheidungseinrichtung 4 sowie der Auswerteeinrichtung 5 auch Bezug zu Bezugszeichen genommen, die im Zusammenhang mit Fig. 1 bereits eingeführt wurden. In der Entscheidungseinrichtung 4 werden die Binärwerte W1..WM zu einer Summe

$$S = \sum_1^M Wi = W1 + W2 + \ldots + WM$$

addiert. Ist diese Summe S größer oder gleich einer vorgebbaren ersten Schwelle T1, so ist mit hoher Wahrscheinlichkeit an der augenblicklichen Bitposition der Informationsdatenfolge 8, die aus dem Schieberegister Se ausgelesen wird, ein Bitfehler aufgetreten. Zur Korrektur wird dann am Ausgang der Fehlerbinärwert e1 gleich 1 ausgegeben und durch eine EXCLUSIV-ODER-Verknüpfung dieses Fehlerbits e1 mit dem entsprechend verzögerten Informationsbit der Informationsdatenfolge 8 durch das EXCLUSIV-ODER-Glied E10 eine Fehlerkorrektur durchgeführt. Bei dem in Fig. 1 dargestellten Ausführungsbeispiel, d.h. für die Werte n gleich 4, k gleich 1, l gleich 10 beträgt der erste vorgebbare Schwellwert T1 beispielsweise 6. Wenn die ermittelte Summe S kleiner als die erste vorgebbare Schwelle T1 ist, so wird am Ausgang der Entscheidungseinrichtung 4 das Fehlersymbol e1 = 0 ausgegeben, so daß das entsprechende Bit der ausgelesenen Informationsdatenfolge 8 durch die EXCLUSIV-ODER-Verknüpfung E10 nicht verändert wird.

Probleme bei der Decodierung treten insbesondere dann auf, wenn die Positionen der Informationsbits der Informationsdatenfolge 11, d.h. das Codewortraster der Empfangsdatenfolge 1 dem Empfänger nicht bekannt sind. Da dies in der Regel so ist, muß die Auswahl von Informations- und Redundanzdatenfolgen im Decoder 200 zunächst willkürlich erfolgen, wodurch es zunächst zu einer fehlerhaften Übertragung kommen kann, wenn das gewählte Codewortraster mit dem richtigen Codewortraster nicht übereinstimmt. Abhilfe ermöglicht eine Überprüfung der korrekten Wahl der Bitposition für die Informationsdatenfolge 11 durch das dritte Fehlersignal e3. Das dritte Fehlersignal e3 wird ebenfalls aus der Summe S = W1 + ... + W9 abgeleitet. Liegt diese Summe S über einer vorgebbaren dritten Schwelle T3, so erhält man eine Information darüber, ob die Lage der Informationsdatenfolge richtig ist oder nicht, d.h. ob der Demultiplexer 2 synchronisiert ist oder nicht. Erreicht oder überschreitet die Summe S innnerhalb eines vorgebbaren Zeitabschnitts mit einer vorgebbaren Häufigkeit die vorgebbare dritte Schwelle T3, wobei für T3 im vorliegenden Beispiel der Wert T3 = 3 gewählt wird, so kann auf eine falsche Synchronisation geschlossen werden. Die Lage der Informationsdatenfolge wird dann zweckmäßigerweise in einer anderen Bitposition der Empfangsdatenfolge 1 gesucht. In diesem Fall wird ein Steuersignal 6 an den Demultiplexer 2 zur Synchronisation geliefert. Die Überwachung der Synchronisation, um z.B. einen durch Bitschlupf verursachten Synchronisationsverlust erkennen zu können, erfolgt ebenso wie bei der Anfangssynchronisation durch Kontrolle des dritten Fehlersignals e3. Eine durch das zweite Fehlersignal e2 festgestellte sehr hohe Bitfehlrate $\hat{s}$ kann von der Auswerteeinrichtung 5 zusätzlich zur Indikation einer falschen Synchronisation herangezogen werden. In diesem Fall ist die zweite Entscheidungseinheit 42 auch mit der zweiten Auswerteeinheit 52 verbunden, wie dies in Fig. gestrichelt dargestellt ist.

Das zweite Fehlersignal e2 wird ebenfalls aus der Summe S abgeleitet. Hierzu wird in der ersten Auswerteeinheit 51 bestimmt, ob die Summenwerte der Summe S, die innerhalb eines vorgebbaren Summenwertebereichs T21, T22 liegen, während eines vorgebbaren Zeitabschnitts eine bestimmte Häufigkeit überschreiten. Ist dies der Fall, so wird auf eine unsichere Entscheidung für die Korrektur geschlossen und das aktuelle Fehlersymbol e2 = 1. Im anderen Fall, wenn die Summe S außerhalb des Schwellenwertebereiches T21, T22 liegt, so wird das Fehlersymbol e2 gleich 0 ausgegeben. Die Bitfehlerrate $\hat{s}$ kann aus der zweiten Fehlerbinärwertfolge e2 nun dadurch ermittelt werden, daß aus dem Anteil von unsicheren Entscheidungen innerhalb des Zeitabschnitts auf die mittlere Bitfehlerrate nach der Decodierung in diesem Zeitabschnitt geschlossen wird. Insbesondere bei einer ungeraden Anzahl von Binärwerten W1..WM ist es sinnvoll, für die Grenzwerte des Summenwertebereichs T21, T22 den selben Schwellwert T2 zu verwenden, der sich dann aus der hälfte der um 1 erhöhten Anzahl der Binärwerte W1..WM ergibt. Die vorgebbaren Zeitabschnitte für das zweite und dritte Fehlersignal können dabei von unterschiedlicher Dauer sein.

Mit Hilfe der zweiten e2 und dritten e3 Fehlerbinärwertfolgen wird es auf einfache Weise möglich, Informationen zur Bitfehlerrate nach der Decodierung sowie ein Synchronisationssignal zur Wortsynchronisation der Empfangsdatenfolge zu erhalten, ohne daß es einen nennenswerten zusätzlichen Aufwand erfordert.

Fig. 3 zeigt ein detaillieres Ausführungsbeispiel für den in Fig. 1 dargestellten Decoder. Dabei werden die bereits im Zusammenhang mit Fig. 1 eingeführten Bezugszeichen verwendet. Das Schieberegister Se weist Register S1..S10 auf. Die Verknüpfungseinrichtung Ve enthält EX-OR-Verknüpfungsglieder E1..E9, die zur Verknüpfung von den Speicherinhalten der Schieberegister S1..S10 mit Daten der Redundanzdatenfolgen 12, 13, 14 zu Syndromfolgen 16, 17, 18 vorgesehen sind. Die Syndromregistereinrichtung SR weist Schieberegister 20, 21, 22 sowie EX-OR-Verknüpfungsglieder E11..E16 auf. Bei dem in Fig. 2 dargestellten Ausführungsbeispiel ist darüber hinaus ein Schalter 7 vorgesehen, über den eine Korrektur der Syndromregistereinrichtung SR durch Zuführung des ersten Fehlersignals e1 optional möglich ist. Die Funktion des Decoders wurde bereits im Zusammenhang mit Fig. 1 erläutert. Die Entscheidungseinrichtung 4 ermittelt dabei die Fehlersignale e1, e2, e3 aus der Summe S nach folgenden Kriterien:

$$e1 = \begin{cases} 1 \text{ für } S \geq T1 \\ 0 \text{ sonst} \end{cases}$$

$$e2 = \begin{cases} 1 \text{ für } T21 \leq S \leq T22 \\ 0 \text{ sonst} \end{cases}$$

$$e3 = \begin{cases} 1 \text{ für } S \geq T3 \\ 0 \text{ sonst} \end{cases}$$

Die Schwellwerte T1, T21, T22 und T3 hängen vom speziellen Faltungscode ab. Für eine ungerade Anzahl M ist es sinnvoll für die beiden Grenzen T21 = T22 denselben Wert T2 = (M+1)/2 einzusetzen. Für einen (4,1,10) Faltungscode betragen die Schwellwerte beispielsweise: T1 = 6, T2 = 5 und T3 = 3.

**Patentansprüche**

1. Übertragungssystem mit einem Empfänger für ein aus einer Informationsdatenfolge (11) und mindestens einer Redundanzdatenfolge (12, 13, 14) bestehendes Digitalsignal (1), wobei die Redundanzdatenfolge (12, 13, 14) aus der Informationsdatenfolge (11) mittels eines Codes gebildet ist, mit einem ersten Speicher (Se) zum Einlesen des Informationssignals (11), mit einer Verknüpfungseinrichtung (Ve) zur Verknüpfung von Speicherinhalten (S1..S10) des ersten Speichers (Se) mit Daten des Redundanzsignals (12, 13, 14) zu mindestens einer Syndromfolge (16, 17, 18), mit einer Syndromregistereinrichtung (SR) mit mindestens einem weiteren Speicher (20, 21, 22) zum Einlesen der Syndrom-folge (16, 17, 18), mit einer Entscheidungseinrichtung (4), die eine Summiereinrichtung (40) zur Bildung einer Summe (S) aus am Speicher (20, 21, 22) der Syndromregistereinrichtung (SR) abgreifbaren Werten (W1..WM) und eine erste Entscheidungseinheit (41) zur Ermittlung eines ersten Fehlersignals (e1) aus der Summe (S) aufweist, und mit einem Verknüpfungsglied (E10) zur Verknüpfung des ersten Fehlersignals (e1) mit einer aus dem ersten Speicher (Se) auszulesenden Informationsdatenfolge (8) zu einer decodierten Informationsdatenfolge (3), dadurch gekennzeichnet, daß die Entscheidungseinrichtung (4) eine zweite Entscheidungseinheit (42) zur Schätzung einer Fehlerrate ($\hat{s}$) des decodierten Informationssignals (3) und/oder eine dritte Entscheidungseinheit (43) zur Ermittlung eines dritten Fehlersignals (e3) zur Synchronisation des Digitalsignals (1) aufweist, wobei die zweite (42) und dritte (43) Entscheidungseinheit jeweils zur Auswertung der aus den Werten (W1..WM) der Speichereinrichtung (SR) gebildeten Summe (S) vorgesehen sind.

2. Übertragungssystem nach Anspruch 1, dadurch gekennzeichnet, daß der Decoder (200) einen Seriell-Parallel-Wandler (2) zur Trennung des Digitalsignals (1) in das Informationssignal (11) und in das Redundanzsignal (12, 13, 14) auf-weist, wobei das dritte Fehlersignal (e3) zur Ableitung eines Steuersignals (6) zur Synchronisation des SeriellParallel-Wandlers (2) vorgesehen ist.

3. Übertragungssystem nach einem der Ansprüche 1 oder 2, dadurch gekennzeichnet, daß die erste Entscheidungseinheit (41) zur Abfrage, ob die Summe (S) eine erste vorgebbare Schwelle (T1) übersteigt, vorgesehen ist.

4. Übertragungssystem nach einem der Ansprüche 1 bis 3, dadurch gekennzeichnet, daß die zweite Entscheidungseinheit (42) zur Abfrage, ob die Summe (S) innerhalb eines vorgebbaren Summenwertebereichs (T21, T22) liegt, vorgesehen ist, wobei die Bitfehlerrate ($\hat{s}$) aus der Häufigkeit der Summenwerte der Summe (S) ermittelt wird, die während eines vorgebbaren Zeitabschnitts innerhalb des vorgebbaren Summenwertebereichs (T21, T22) liegen.

5. Übertragungssystem nach einem der Ansprüche 1 bis 4, dadurch gekennzeichnet, daß die dritte Entscheidungseinheit (43) zur Abfrage, ob die Summe (S) größer oder gleich eine vorgebbare dritte Schwelle (T3) ist, vorgesehen ist, wobei eine Verschiebung der Empfangsdatenfolge (1) dann erfolgt, wenn die Summenwerte der Summe (S), die größer oder gleich der vorgebbaren dritten Schwelle (T3) sind, während eines vorgebbaren Zeitabschnitts eine vorgebbare Häufigkeit überschreiten.

6. Übertragungssystem nach einem der Ansprüche 1 bis 5, dadurch gekennzeichnet, daß der Decoder eine Auswerteeinrichtung (5) zur Auswertung mindestens eines Fehlersignals (e1, e2, e3) aufweist, wobei zur Schätzung der Bitfehlerrate ($\hat{s}$) der decodierten Informationsdatenfolge (3) eine mit der zweiten Entscheidungseinheit verbundene erste Auswerteeinheit (51) und/- oder zur Ermittlung des Steuersignals (6) eine mit der dritten Entscheidungseinheit (43) verbundene zweite Auswerteeinheit (52) vorgesehen ist.

7. Übertragungssystem nach einem der Ansprüche 1 bis 6, dadurch gekennzeichnet, daß die zweite Auswerteeinheit (52) auch mit der zweiten Entscheidungseinheit (42) verbunden ist.

8. Übertragungssystem nach einem der Ansprüche 1 bis 7, dadurch gekennzeichnet, daß zur Zuführung des ersten Fehlersignals (e1) an die Speicher (20, 21, 22) der Speichereinrichtung (SR) ein Schalter (7) vorgesehen ist, dem das erste Fehlersignal (e1) zugeführt wird.

9. Decoder (200) für ein aus einer Informationsdatenfolge (11) und mindestens einer Redundanzdatenfolge (12, 13, 14) bestehendes Digitalsignal (1), wobei die Redundanzdatenfolge (12, 13, 14) aus der Informationsdatenfolge (11) mittels eines Codes gebildet ist, mit einem ersten Speicher (Se) zum Einlesen des Informationssignals (11), mit einer Verknüpfungseinrichtung (Ve) zur Verknüpfung von Speicherinhalten (S1..S10) des ersten Speichers (Se) mit Daten des Redundanzsignals (12, 13, 14) zu mindestens einer Syndromfolge (16, 17, 18), mit einer Syndromregistereinrichtung (SR) mit mindestens einem weiteren Speicher (20, 21, 22) zum Einlesen der Syndromfolge (16, 17, 18), mit einer Entscheidungseinrichtung (4), die eine Summiereinrichtung (40) zur Bildung einer Summe (S) aus am Speicher (20, 21, 22) der Syndromregistereinrichtung (SR) abgreifbaren Werten (W1..WM) und eine erste Entscheidungseinheit (41) zur Ermittlung eines ersten Fehlersignals (e1) aus der Summe (S) aufweist, und mit einem Verknüpfungsglied (E10) zur Verknüpfung des ersten Fehlersignals (e1) mit einer aus dem ersten Speicher (Se) auszulesenden Informationsdatenfolge (8) zu einer decodierten Informationsdatenfolge (3),

dadurch gekennzeichnet,

daß die Entscheidungseinrichtung (4) eine zweite Entscheidungseinheit (42) zur Schätzung einer Bitfehlerrate ($\hat{s}$) des decodierten Informationssignals (3) und/oder eine dritte Entscheidungseinheit (43) zur Ermittlung eines dritten Fehlersignals (e3) zur Synchronisation des Digitalsignals (1) aufweist, wobei die zweite (42) und dritte (43) Entscheidungseinheit jeweils zur Auswertung der aus den Werten (W1..WM) der Speichereinrichtung (SR) gebildeten Summe (S) vorgesehen sind.

FIG.1

FIG.2

FIG.3

EP 0 573 116 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 806 647 (ALAN SWAINE DOHNE)<br>* Spalte 3, Zeile 38 - Zeile 60 *<br>* Spalte 5, Zeile 21 - Zeile 62 *<br>--- | 1,9 | H04L7/04<br>H04L1/00 |
| A | EP-A-0 100 818 (ANT NACHRICHTENTECHNIK GMBH)<br>* Seite 3, Zeile 33 - Seite 5, Zeile 11 *<br>--- | 1,9 | |
| A | EP-A-0 026 516 (N.V. PHILIPS' GLOEILAMPENFABRIEK.)<br>* Seite 2, Zeile 24 - Seite 3, Zeile 36 *<br>* Seite 7, Zeile 7 - Zeile 19 *<br><br>----- | 1,9 | |
| | | | **RECHERCHIERTE SACHGEBIETE (Int. Cl.5)**<br><br>H04L<br>H03M |

Der vorliegende Recherchenbericht wurde für alle Patentansprüche erstellt

| Recherchenort | Abschlußdatum der Recherche | Prüfer |
|---|---|---|
| DEN HAAG | 09 SEPTEMBER 1993 | VAN DEN BERG J.G.J. |